# EUROPEAN PATENT APPLICATION

(11) **EP 1 901 436 A2**
(43) Date of publication of application: **19.03.2008**
(21) Application number: 07016675.6
(22) Date of filing: 24.08.2007
(51) Int. Cl.: H03M 13/25, H04L 27/34, H03M 13/11

(54) **Bit mapping scheme for an LDPC coded 16APSK system**

(30) Priority: 18.09.2006 WO PCT/CN2006/002423
(71) Applicant: Availink, Inc., Germantown MD 20874 (US)
(72) Inventor: Li, Xunchun, 100055 Beijing (CN); Sun, Fengwen, Germantown, MD 20874 (US); Zhang, Juntan, North Potomac, MD 20878 (US)
(74) Representative: Plougmann & Vingtoft A/S

(57) **Abstract**

A digital communication system, having a transmitter to transmit a digital signal; and a receiver to receive the digital signal; wherein the digital signal utilizes a 16APSK system, and the signal is bit-mapped using gray mapping. The 16APSK modulation scheme is used to build up a low-density parity-check (LDPC) coded modulation system.

## Description

### FIELD OF THE INVENTION

The invention relates to digital communications and in particular to a bit mapping scheme for a low-density parity-check (LDPC) coded 16APSK (adaptive phase-shift keying) system.

### BACKGROUND OF THE INVENTION

Forward Error Control (FEC) coding is used by communications systems to ensure reliable transmission of data across noisy communication channels. Based on Shannon's theory, these communication channels exhibit a fixed capacity that can be expressed in terms of bits per symbol at a given signal-to-noise ratio (SNR), which is defined as the Shannon limit. One of the research areas in communication and coding theory involves devising coding schemes offering performance approaching the Shannon limit while maintaining a reasonable complexity. It has been shown that LDPC codes using Belief Propagation (BP) decoding provide performance close to the Shannon limit with tractable encoding and decoding complexity.

In *"*Bit-Reliability Mapping in LDPC-Codes Modulation systems", Yan Li and William Ryan, IEEE Communications Letters, vol. 9, no. 1, January 2005, the authors studied the performance of LDPC-coded modulation systems with 8PSK (phase-shift keying). With the authors' proposed bit reliability mapping strategy, about 0.15 dB performance improvement over the non-interleaving scheme is achieved. Also the authors show that gray mapping is more suitable for high order modulation than other mapping scheme such as natural mapping.

### SUMMARY OF THE INVENTION

It is an object of the invention to present improved digital communications transmitter and reciever. This object is achieved by the subject matter of the independent claims.

Various embodiments of the invention are directed to a bit mapping scheme in a 16APSK modulation system. The techniques of these embodiments are particularly well suited for use with LDPC codes.

LDPC codes were first described by Gallager in the 1960s. LDPC codes perform remarkably close to the Shannon limit. A binary (*N, K*) LDPC code, with a code length *N* and dimension *K*, is defined by a parity check matrix **H** of (*N-K*) rows and *N* columns. Most entries of the matrix **H** are zeros and only a small number the entries are ones, hence the matrix **H** is sparse. Each row of the matrix **H** represents a check sum, and each column represents a variable, e. g. a bit or symbol. The LDPC codes described by Gallager are regular, i. e. the parity check matrix **H** has constant-weight rows and columns.

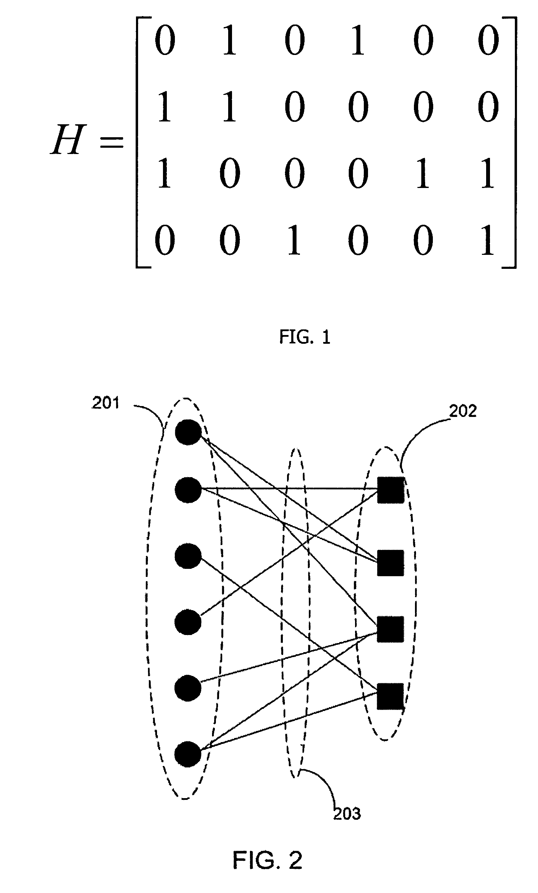

Regular LDPC codes can be extended to form irregular LDPC codes, in which the weight of rows and columns vary. An irregular LDPC code is specified by degree distribution polynomials *v*(*x*) and *c*(*x*), which define the variable and check node degree distributions, respectively. More specifically, the irregular LDPC codes may be defined as follows: $v \left(x\right) = {\sum }_{j = 1}^{{d}_{v ⁢ max}} {v}_{j} ⁢ {x}^{j - 1} ,$
and $c \left(x\right) = {\sum }_{j = 1}^{{d}_{c ⁢ max}} {c}_{j} ⁢ {x}^{j - 1} ,$
where the variables *d*_{*v*max} and *d*_{*c*max} are a maximum variable node degree and a check node degree, respectively, and *vⱼ (cⱼ* ) represents the fraction of edges emanating from variable (check) nodes of degree j. While irregular LDPC codes can be more complicated to represent and/or implement than regular LDPC codes, it has been shown, both theoretically and empirically, that irregular LDPC codes with properly selected degree distributions outperform regular LDPC codes. FIG. 1 illustrates a parity check matrix representation of an exemplary irregular LDPC code of codeword length six.

LDPC codes can also be represented by bipartite graphs, or Tanner graphs. In Tanner graph, one set of nodes called variable nodes (or bit nodes) corresponds to the bits of the codeword and the other set of nodes called constraints nodes (or check nodes) corresponds the set of parity check constrains which define the LDPC code. Bit nodes and check nodes are connected by edges, and a bit node and a check node are said to be neighbors or adjacent if they are connected by an edge. Generally, it is assumed that a pair of nodes is connected by at most one edge.

FIG. 2 illustrates a bipartite graph representation of the irregular LDPC code illustrated in FIG. 1.

LDPC codes can be decoded in various ways such as majority-logic decoding and iterative decoding. Because of the structures of their parity check matrices, LDPC codes are majority-logic decodable. Although majority-logic decoding requires the least complexity and achieves reasonably good error performance for decoding some types of LDPC codes with relatively high column weights in their parity check matrices (e. g. Euclidean geometry LDPC and projective geometry LDPC codes), iterative decoding methods have received more attention due to their better performance versus complexity tradeoffs. Unlike majority-logic decoding, iterative decoding processes the received symbols recursively to improve the reliability of each symbol based on constraints that specify the code. In a first iteration, an iterative decoder only uses a channel output as input, and generates reliability output for each symbol.

Subsequently, the output reliability measures of the decoded symbols at the end of each decoding iteration are used as inputs for the next iteration. The decoding process continues until a stopping condition is satisfied, after which final decisions are made based on the output reliability measures of the decoded symbols from the last iteration. According to the different properties of reliability measures used during each iteration, iterative decoding algorithms can be further divided into hard decision, soft decision and hybrid decision algorithms. The corresponding popular algorithms are iterative bit-flipping (BF), belief propagation (BP), and weighted bit-flipping (WBF) decoding, respectively. Since BP algorithms have been proven to provide maximum likelihood decoding when the underlying Tanner graph is acyclic, they have become the most popular decoding methods.

BP for LDPC codes is a type of message passing decoding. Messages transmitted along the edges of a graph are log-likelihood ratio (LLR) $log ⁢ \frac{{p}_{0}}{{p}_{1}}$ associated with variable nodes corresponding to codeword bits. In this expression *p*₀ and *p*₁ denote the probability that the associated bit value becomes either a 0 or a 1, respectively. BP decoding generally includes two steps, a horizontal step and a vertical step. In the horizontal step, each check node *cₘ* sends to each adjacent bit *bₙ* a check-to-bit message which is calculated based on all bit-to-check messages incoming to the check *cₘ* except one from bit *bₙ.* In the vertical step, each bit node *bₙ* sends to each adjacent check node *cₘ* a bit-to-check message which is calculated based on all check-to-bit messages incoming to the bit *bₙ* except one from check node *cₘ,* These two steps are repeated until a valid codeword is found or the maximum number of iterations is reached.

Because of its remarkable performance with BP decoding, irregular LDPC codes are among the best for many applications. Various irregular LDPC codes have been accepted or being considered for various communication and storage standards, such as DVB-S2/DAB, wireline ADSL, IEEE 802.1 In, and IEEE 802.16.

The threshold of an LDPC code is defined as the smallest SNR value at which, as the codeword length tends to infinity, the bit error probability can be made arbitrarily small. The value of threshold of an LDPC code can be determined by analytical tool called density evolution.

The concept of density evolution can also be traced back to Gallager's results. To determine the performance of BF decoding, Gallager derived formulas to calculate the output bit error rate (BER) for each iteration as a function of the input BER at the beginning of the iteration, and then iteratively calculated the BER at a given iteration. For a continuous alphabet, the calculation is more complex. The probability density functions (pdf) of the belief messages exchanged between bit and check nodes need to be calculated from one iteration to the next, and the average BER for each iteration can be derived based on these pdf. In both check node processing and bit node processing, each outgoing belief message is a function of incoming belief messages. For a check node of degree *d_{c},* each outgoing message *U* can be expressed by a function of *d_{c} -*1 incoming messages, $U = {F}_{c} ⁢ \left({V}_{1}⁢{V}_{2}…{V}_{{d}_{c} - 1}\right) ,$
where *F_{c}* denotes the check node processing function which is determined from BP decoding. Similarly, for bit node of degree *dᵥ,* each outgoing message *V* can be expressed by a function of *dᵥ-*1 incoming messages and the channel belief message *U_{ch}* , $U = {F}_{V} ⁢ \left({U}_{ch}⁢{U}_{1}⁢{U}_{2}…{V}_{{d}_{v} - 1}\right) ,$
where *Fᵥ* denotes the bit node processing function. Although for both check and bit node processing, the pdf of an outgoing message can be derived based on the pdf of incoming messages for a given decoding algorithm, there may exist an exponentially large number of possible formats of incoming messages. Therefore the process of density evolution seems intractable. Fortunately, it has been proven in that for a given message-passing algorithm and noisy channel, if some symmetry conditions are satisfied, then the decoding BER is independent of the transmitted sequence *x.* That is to say, with the symmetry assumptions, the decoding BER of all-zero transmitted sequence *x* =1 is equal to that of any randomly chosen sequence, thus the derivation of density evolution can be considerably simplified. The symmetry conditions required by efficient density evolution are channel symmetry, check node symmetry, and bit node symmetry. Another assumption for the density evolution is that the Tanner graph is cyclic free.

According to these assumptions, the incoming messages to bit and check nodes are independent, and thus the derivation for the pdf of the outgoing messages can be considerably simplified. For many LDPC codes with practical interests, the corresponding Tanner graph contains cycles. When the minimum length of a cycle (or girth) in a Tanner graph of an LDPC code is equal to 4 × *l* , then the independence assumption does not hold after the *l-*th decoding iteration with the standard BP decoding. However, for a given iteration number, as the code length increases, the independence condition is satisfied for an increasing iteration number. Therefore, the density evolution predicts the asymptotic performance of an ensemble of LDPC codes and the "asymptotic" nature is in the sense of code length.

According to various embodiments of the invention, the bit mapping schemes provide good threshold of LDPC codes. Furthermore, the bit mapping schemes can facilitate the design of an interleaving arrangement in a 16APSK modulation system.

According to various embodiments of the invention, the disclosed bit mapping offers good performance of LDPC coded 16APSK system and simplifies an interleaving arrangement in 16APSK systems.

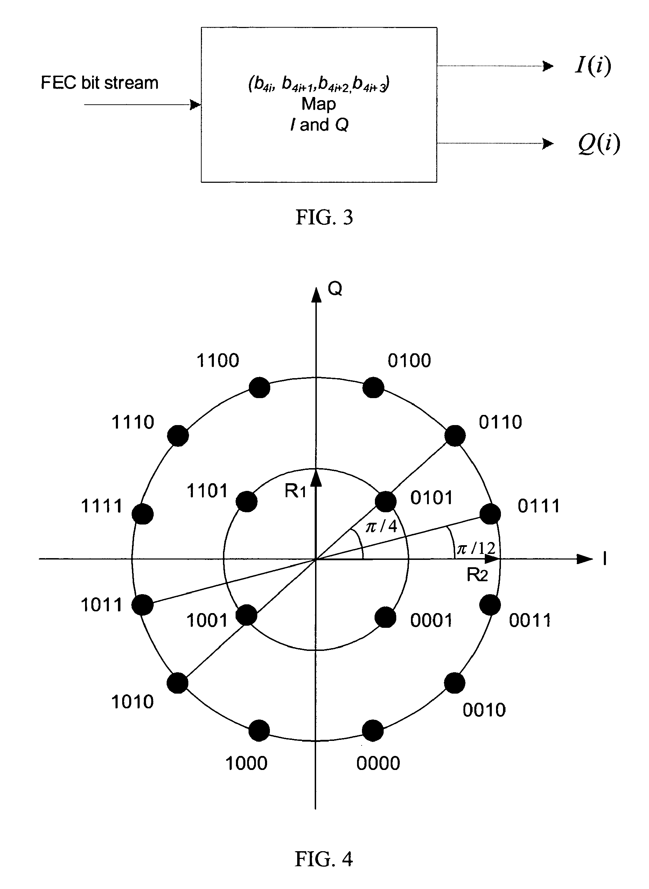

According to various embodiments of the invention, a method of bit mapping in a 16APSK system, wherein the system utilizes an FEC code, comprises: transmitting a digital signal from a transmitter; and receiving the digital signal at a receiver; wherein the digital signal utilizes a 16APSK system with FEC coding, and the signal is bit-mapped prior to the transmitting according to a formula embodied by FIG. 4.

According to various embodiments of the invention, the FEC code is regular LDPC code.

According to various embodiments of the invention, the FEC code is irregular LDPC code.

According to various embodiments of the invention, the FEC code is regular repeat-accumulate code.

According to various embodiments of the invention, the FEC code is irregular repeat-accumulate code.

According to various embodiments of the invention, a digital communication system comprises: a transmitter to transmit a digital signal; and a receiver to receive the digital signal; wherein the digital signal utilizes a 16APSK system with FEC coding, and the signal is bit-mapped prior to the transmitting according to a formula embodied by FIG. 4.

According to various embodiments of the invention, a digital communication system comprises: a transmitter to transmit a digital signal; and a receiver to receive the digital signal; wherein the digital signal utilizes a 16APSK system with FEC coding, and the signal is bit-mapped using gray mapping, and bits of the digital signal are ordered based on the values of a log likelihood ratio from a communications channel.

### BRIEF DESCRIPTION OF THE DRAWINGS

The invention is illustrated by way of example, and not by way of limitation, in the figures of the corresponding drawings and in which like reference numerals refer to similar elements and in which:

FIG. 1 is a parity check matrix representation of an exemplary irregular LDPC code of codeword length six.

FIG. 2 illustrates a bipartite graph representation of the irregular LDPC code illustrated in FIG. 1.

FIG. 3 illustrates the bit mapping block in 16APSK modulation, according to various embodiments of the invention.

FIG. 4 illustrates a bit map for 16APSK symbol, according to various embodiments of the invention.

FIG. 5 depicts an example of a communications system which employs LDPC codes and 16APSK modulation, according to various embodiments of the invention.

FIG. 6 depicts an example of a transmitter employing 16APSK modulation in FIG. 5, according to various embodiments of the invention.

FIG. 7 depicts an example of a receiver employing 16APSK demodulation in FIG. 5, according to various embodiments of the invention.

### DETAILED DESCRIPTION OF THE INVENTION

Referring to the accompanying drawings, a detailed description will be given of exemplary encoded bit mapping methods using LDPC codes according to various embodiments of the invention.

Although the invention is described with respect to LDPC codes, it is recognized that the bit mapping approach can be utilized with other codes. Furthermore, it is recognized that this approach can be implemented with uncoded systems.

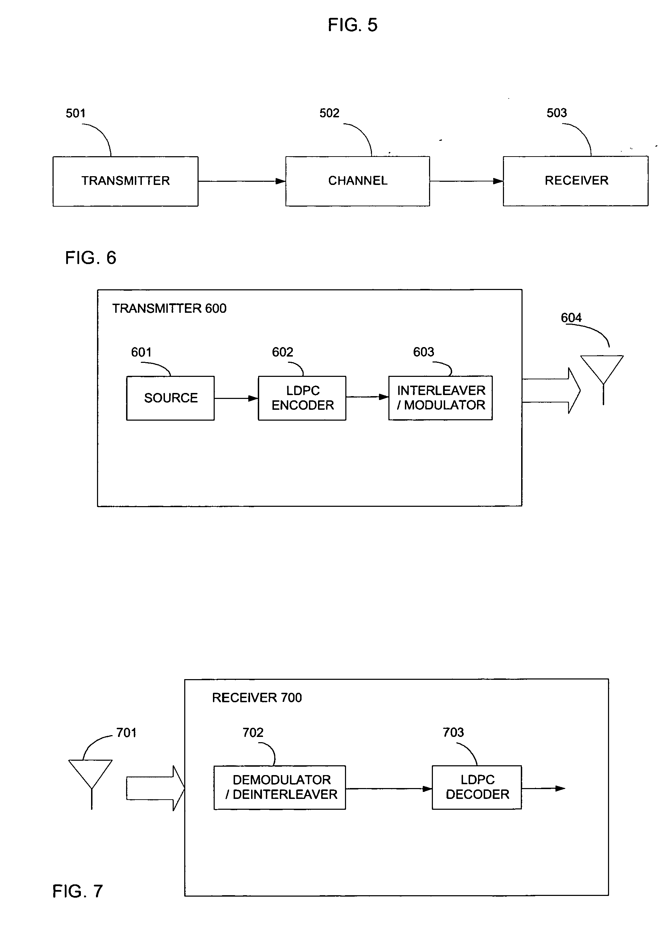

FIG. 5 is an exemplary diagram of a communications system employing LDPC codes with 16APSK modulation, according to various embodiments of the invention. The exemplary communications system includes a transmitter 501 which generates signal waveforms across a communication channel 502 to a receiver 503. The transmitter 501 contains a message source for producing a discrete set of possible messages. Each of these messages corresponds to a signal waveform. The waveforms enter the channel 502 and are corrupted by noise. LDPC codes are employed to reduce the disturbances introduced by the channel 502, and a 16APSK modulation scheme is employed to transform LDPC encoded bits to signal waveforms.

FIG. 6 depicts an exemplary transmitter 501; 600 in the communications system of FIG. 5 which employs LDPC codes and 16APSK modulation. The LDPC encoder 602 encodes information bits from source 601 into LDPC codewords. The mapping from each information block to each LDPC codeword is specified by the parity check matrix (or equivalently the generator matrix) of the LDPC code. The LDPC codeword is interleaved and modulated to signal waveforms by the interleaver/modulator 603 based on a 16APSK bit mapping scheme. These signal waveforms are sent to a transmit antenna 604 and propagated to a receiver 700 shown in FIG. 7.

FIG. 7 depicts an exemplary receiver 503; 700 in FIG. 5 which employs LDPC codes and 16APSK demodulator. Signal waveforms are received by the receiving antenna 701 and distributed to demodulator/deinterleavor 702. Signal waveforms are demodulated by demodulator and deinterleaved by deinterleavor and then distributed to a LDPC decoder 703 which iteratively decodes the received messages and output estimations of the transmitted codeword. The 16APSK demodulation rule employed by the demodulator/deinterleaver 702 should match with the 16APSK modulation rule employed by the interleaver/modulator 603.

According to various embodiments of the invention, as shown in FIG. 3, the exemplary 16APSK bit-to-symbol mapping circuit utilizes four bits *(b*₄*ᵢ, b*_{4*i+*1,} *b*_{4*i*+2,} *b*_{4*i*+3}) each iteration and maps them into an *I* value and a *Q* value, with *i*=0, 1, 2, ... The bit mapping logic is shown in FIG. 4. According to various embodiments of the invention, the mappings of bits are defined by:$\left(I\left(i\right),Q\left(i\right)\right) = { \begin{matrix}\left({R}_{2}⁢sin\left(π/12\right),-{R}_{2}⁢cos\left(π/12\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢0\right) \\ \left({R}_{1}⁢sin\left(π/4\right),-{R}_{1}⁢cos\left(π/4\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢1\right) \\ \left({R}_{2}⁢sin\left(π/4\right),-{R}_{2}⁢cos\left(π/4\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢1⁢0\right) \\ \left({R}_{2}⁢cos\left(π/12\right),-{R}_{2}⁢sin\left(π/12\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢1⁢1\right) \\ ( {R}_{2} ⁢ sin \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢0⁢0\right) \\ ( {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢0⁢1\right) \\ ( {R}_{2} ⁢ sin \left(π/4\right) , {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢1⁢0\right) \\ \begin{matrix}( {R}_{2} ⁢ cos \left(π/12\right) , {R}_{2} ⁢ sin \left(π/12\right) ) ,\end{matrix} & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢1⁢1\right) \\ \begin{matrix}( - {R}_{2} ⁢ sin \left(π/12\right) , - {R}_{2} ⁢ cos \left(π/12\right) ) ,\end{matrix} & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢0\right) \\ ( - {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢0⁢1\right) \\ ( - {R}_{2} ⁢ sin \left(π/4\right) , - {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢1⁢0\right) \\ ( - {R}_{2} ⁢ cos \left(π/12\right) , - {R}_{2} ⁢ sin \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢1⁢1\right) \\ ( - {R}_{2} ⁢ sin \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢0⁢0\right) \\ ( - {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢0⁢0\right) \\ ( - {R}_{2} ⁢ sin \left(π/4\right) , {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢1⁢0\right) \\ ( - {R}_{2} ⁢ cos \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢1⁢1\right)\end{matrix}$

According to various embodiments of the invention, the bit mapping scheme of FIG. 4 uses gray mapping, meaning the binary representations of adjacent symbols differ by only one bit. Density evolution analysis shows that given an LDPC coded 16APSK system, the exemplary gray mapping scheme can provide the best threshold. The bit mapping scheme of FIG. 4 also arranges bits in an order based on the values of a log likelihood ratio from the communications channel. This arrangement simplifies the design of interleaving scheme for 16APSK system.

Although specific embodiments have been illustrated and described herein, it will be appreciated by those of ordinary skill in the art, that any arrangement which is calculated to achieve the same purpose may be substituted for the specific embodiments shown. It is to be understood, that the above description is intended to be illustrative and not restrictive. This application is intended to cover any adaptations or variations of the invention. Combinations of the above embodiments and many other embodiments will be apparent to those of skill in the art upon reading and understanding the above description. The scope of the invention includes any other embodiments and applications in which the above structures and methods may be used. The scope of the invention should, therefore, be determined with reference to the appended claims along with the full scope of equivalents to which such claims are entitled.

## Claims

1. A digital communications transmitter (501; 600) to transmit a digital signal, wherein:
the transmitter (501; 600) modulates a mapping group having four bits *(b*_{4*i*}, *b*_{4*i*+1}) *b*_{4*i*+2}*, b*_{4*i*+3}), for *i*=0, 1, 2, ..., to a 16APSK symbol based on following formula: $\left(I\left(i\right),Q\left(i\right)\right) = { \begin{matrix}\left({R}_{2}⁢sin\left(π/12\right),-{R}_{2}⁢cos\left(π/12\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢0\right) \\ \left({R}_{1}⁢sin\left(π/4\right),-{R}_{1}⁢cos\left(π/4\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢1\right) \\ \left({R}_{2}⁢sin\left(π/4\right),-{R}_{2}⁢cos\left(π/4\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢1⁢0\right) \\ \left({R}_{2}⁢cos\left(π/12\right),-{R}_{2}⁢sin\left(π/12\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢1⁢1\right) \\ ( {R}_{2} ⁢ sin \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢0⁢0\right) \\ ( {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢0⁢1\right) \\ ( {R}_{2} ⁢ sin \left(π/4\right) , {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢1⁢0\right) \\ \begin{matrix}( {R}_{2} ⁢ cos \left(π/12\right) , {R}_{2} ⁢ sin \left(π/12\right) ) ,\end{matrix} & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢1⁢1\right) \\ \begin{matrix}( - {R}_{2} ⁢ sin \left(π/12\right) , - {R}_{2} ⁢ cos \left(π/12\right) ) ,\end{matrix} & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢0\right) \\ ( - {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢0⁢1\right) \\ ( - {R}_{2} ⁢ sin \left(π/4\right) , - {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢1⁢0\right) \\ ( - {R}_{2} ⁢ cos \left(π/12\right) , - {R}_{2} ⁢ sin \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢1⁢1\right) \\ ( - {R}_{2} ⁢ sin \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢0⁢0\right) \\ ( - {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢0⁢0\right) \\ ( - {R}_{2} ⁢ sin \left(π/4\right) , {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢1⁢0\right) \\ ( - {R}_{2} ⁢ cos \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢1⁢1\right)\end{matrix} ;$
and
*R*₁ is a radius of an inner ring and *R*₂ is a radius of an outer ring.

2. A digital communications transmitter (501; 600) to transmit a digital signal, wherein:
the digital signal utilizes a 16APSK system with FEC coding;
the digital signal is bit-mapped using gray mapping; and
bits of the digital signal are ordered based on the values of a log likelihood ratio from a communications channel.

3. The digital communications transmitter (501; 600) of claim 2, wherein:
the FEC code is regular LDPC code.

4. The digital communications transmitter (501; 600) of claim 2, wherein:
the FEC code is irregular LDPC code.

5. The digital communications transmitter (501; 600) of claim 2, wherein:
the FEC code is regular repeat-accumulate code.

6. The digital communications transmitter (501; 600) of claim 2, wherein:
the FEC code is irregular repeat-accumulate code.

7. A digital communications receiver (503; 700) to receive a digital signal, comprising:
a demodulator (702) to map 16APSK symbols to estimating messages of groups of four bits *(b*_{4*i*}, *b*_{4*i+*1}, *b*_{4*i+*2}, *b*_{4*i+*3}*)*, for *i=*0*,* 1, 2, ..., based on following 16APSK constellation specification: $\left(I\left(i\right),Q\left(i\right)\right) = { \begin{matrix}\left({R}_{2}⁢sin\left(π/12\right),-{R}_{2}⁢cos\left(π/12\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢0\right) \\ \left({R}_{1}⁢sin\left(π/4\right),-{R}_{1}⁢cos\left(π/4\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢1\right) \\ \left({R}_{2}⁢sin\left(π/4\right),-{R}_{2}⁢cos\left(π/4\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢1⁢0\right) \\ \left({R}_{2}⁢cos\left(π/12\right),-{R}_{2}⁢sin\left(π/12\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢1⁢1\right) \\ ( {R}_{2} ⁢ sin \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢0⁢0\right) \\ ( {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢0⁢1\right) \\ ( {R}_{2} ⁢ sin \left(π/4\right) , {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢1⁢0\right) \\ \begin{matrix}( {R}_{2} ⁢ cos \left(π/12\right) , {R}_{2} ⁢ sin \left(π/12\right) ) ,\end{matrix} & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢1⁢1\right) \\ \begin{matrix}( - {R}_{2} ⁢ sin \left(π/12\right) , - {R}_{2} ⁢ cos \left(π/12\right) ) ,\end{matrix} & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢0\right) \\ ( - {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢0⁢1\right) \\ ( - {R}_{2} ⁢ sin \left(π/4\right) , - {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢1⁢0\right) \\ ( - {R}_{2} ⁢ cos \left(π/12\right) , - {R}_{2} ⁢ sin \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢1⁢1\right) \\ ( - {R}_{2} ⁢ sin \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢0⁢0\right) \\ ( - {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢0⁢0\right) \\ ( - {R}_{2} ⁢ sin \left(π/4\right) , {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢1⁢0\right) \\ ( - {R}_{2} ⁢ cos \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢1⁢1\right)\end{matrix} ;$
and
wherein *R*₁ is a radius of an inner ring and *R*₂ is a radius of an outer ring.

8. A digital communications system comprising the transmitter (501; 600) of one of claims 1 to 6 or the receiver (503; 700) of claim 7 or both.

9. A method of digital mapping in a 16APSK system, comprising:
transmitting a digital signal from a transmitter (501; 600); and
receiving the digital signal at a receiver (503; 700);
wherein:
the digital signal is bit-mapped prior to the transmitting based on following formula: $\left(I\left(i\right),Q\left(i\right)\right) = { \begin{matrix}\left({R}_{2}⁢sin\left(π/12\right),-{R}_{2}⁢cos\left(π/12\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢0\right) \\ \left({R}_{1}⁢sin\left(π/4\right),-{R}_{1}⁢cos\left(π/4\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢1\right) \\ \left({R}_{2}⁢sin\left(π/4\right),-{R}_{2}⁢cos\left(π/4\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢1⁢0\right) \\ \left({R}_{2}⁢cos\left(π/12\right),-{R}_{2}⁢sin\left(π/12\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢1⁢1\right) \\ ( {R}_{2} ⁢ sin \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢0⁢0\right) \\ ( {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢0⁢1\right) \\ ( {R}_{2} ⁢ sin \left(π/4\right) , {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢1⁢0\right) \\ \begin{matrix}( {R}_{2} ⁢ cos \left(π/12\right) , {R}_{2} ⁢ sin \left(π/12\right) ) ,\end{matrix} & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢1⁢1\right) \\ \begin{matrix}( - {R}_{2} ⁢ sin \left(π/12\right) , - {R}_{2} ⁢ cos \left(π/12\right) ) ,\end{matrix} & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢0\right) \\ ( - {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢0⁢1\right) \\ ( - {R}_{2} ⁢ sin \left(π/4\right) , - {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢1⁢0\right) \\ ( - {R}_{2} ⁢ cos \left(π/12\right) , - {R}_{2} ⁢ sin \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢1⁢1\right) \\ ( - {R}_{2} ⁢ sin \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢0⁢0\right) \\ ( - {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢0⁢0\right) \\ ( - {R}_{2} ⁢ sin \left(π/4\right) , {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢1⁢0\right) \\ ( - {R}_{2} ⁢ cos \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢1⁢1\right)\end{matrix} ;$
and
*R*₁ is a radius of an inner ring and *R*₂ is a radius of an outer ring.

10. The method of claim 10, wherein:
the 16APSK system utilizes an FEC code.

11. A computer-readable medium to store a computer program, wherein:
a mapping group of four bits (*b*_{4*i*}, *b*_{4*i*+1}, *b*_{4*i+*2}, *b*_{4*i*+3)}, for *i*=0, 1, 2, ..., is modulated to a 16APSK symbol based on following formula: $\left(I\left(i\right),Q\left(i\right)\right) = { \begin{matrix}\left({R}_{2}⁢sin\left(π/12\right),-{R}_{2}⁢cos\left(π/12\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢0\right) \\ \left({R}_{1}⁢sin\left(π/4\right),-{R}_{1}⁢cos\left(π/4\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢1\right) \\ \left({R}_{2}⁢sin\left(π/4\right),-{R}_{2}⁢cos\left(π/4\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢1⁢0\right) \\ \left({R}_{2}⁢cos\left(π/12\right),-{R}_{2}⁢sin\left(π/12\right)\right) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢1⁢1\right) \\ ( {R}_{2} ⁢ sin \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢0⁢0\right) \\ ( {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢0⁢1\right) \\ ( {R}_{2} ⁢ sin \left(π/4\right) , {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢1⁢0\right) \\ \begin{matrix}( {R}_{2} ⁢ cos \left(π/12\right) , {R}_{2} ⁢ sin \left(π/12\right) ) ,\end{matrix} & \left({b}_{4 ⁢ i}⁢{b}_{4 ⁢ i + 1}⁢{b}_{4 ⁢ i + 2}⁢{b}_{4 ⁢ i + 3}\right) = \left(0⁢1⁢1⁢1\right) \\ \begin{matrix}( - {R}_{2} ⁢ sin \left(π/12\right) , - {R}_{2} ⁢ cos \left(π/12\right) ) ,\end{matrix} & \left({b}_{4 ⁢ i}⁢{b}_{4 ⁢ i + 1}⁢{b}_{4 ⁢ i + 2}⁢{b}_{4 ⁢ i + 3}\right) = \left(0⁢0⁢0⁢0\right) \\ ( - {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢0⁢1\right) \\ ( - {R}_{2} ⁢ sin \left(π/4\right) , - {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢1⁢0\right) \\ ( - {R}_{2} ⁢ cos \left(π/12\right) , - {R}_{2} ⁢ sin \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢0⁢1⁢1\right) \\ ( - {R}_{2} ⁢ sin \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢0⁢0\right) \\ ( - {R}_{1} ⁢ sin \left(π/4\right) , {R}_{1} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢0⁢0\right) \\ ( - {R}_{2} ⁢ sin \left(π/4\right) , {R}_{2} ⁢ cos \left(π/4\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢1⁢0\right) \\ ( - {R}_{2} ⁢ cos \left(π/12\right) , {R}_{2} ⁢ cos \left(π/12\right) ) , & \left({b}_{4 ⁢ i}⁢{b}_{4 ⁢ i + 1}⁢{b}_{4 ⁢ i + 2}⁢{b}_{4 ⁢ i + 3}\right) = \left(1⁢1⁢1⁢1\right)\end{matrix} ;$
and
*R*₁ is a radius of an inner ring and *R*₂ is a radius of an outer ring.
